# EUROPEAN PATENT APPLICATION

(11) **EP 1 729 330 A1**
(43) Date of publication of application: **06.12.2006**
(21) Application number: 05721587.3
(22) Date of filing: 22.03.2005
(51) Int. Cl.: H01L 21/203, C23C 14/14

(54) **METHOD AND EQUIPMENT FOR FORMING CRYSTALLINE SILICON THIN FILM**

(30) Priority: 26.03.2004 JP 2004091709
(71) Applicant: Nissin Electric Co., Ltd., Kyoto-shi, Kyoto 615-8686 (JP)
(72) Inventor: TOMYO, Atsushi c/o Nissin Electric Co., Ltd., Kyoto-shi, Kyoto 615-8686 (JP); TAKAHASHI, Eiji c/o Nissin Electric Co., Ltd., Kyoto-shi, Kyoto 615-8686 (JP)
(74) Representative: Barz, Peter
(86) International application number: PCT/JP2005/005660
(87) International publication number: WO 2005/093797

(57) **Abstract**

A hydrogen gas is supplied into a deposition chamber (10) accommodating a silicon sputter target (2) and a deposition target substrate (S), a high-frequency power is applied to the gas to generate plasma exhibiting Hα/SiH* from 0.3 to 1.3 in the deposition chamber, and chemical sputtering is effected on the silicon sputter target (2) by the plasma to form a crystalline silicon thin film on the substrate (2). A crystalline silicon thin film of a good quality can be formed inexpensively and safely at a relatively low temperature.

## Description

### TECHNICAL FIELD

The present invention relates to a method and an apparatus for forming a crystalline silicon thin film.

### BACKGROUND ART

Polycrystalline silicon, nanocrystalline silicon and others have been known as crystalline silicon, and these can be used for various purposes.

Polycrystalline silicon thin films have been used, e.g., as materials of TFT (thin film transistor) switches arranged at pixels of liquid crystal displays as well as materials of various integrated circuits, solar cells and others. It has been expected to use nanocrystalline silicon in nonvolatile memories, light emitting elements and optical sensitizer.

For example, such methods of forming the polycrystalline silicon thin films have been known that a deposition target substrate is kept at a temperature of 800 deg. C or higher, and a CVD method such as a plasma CVD method or a PVD method such as a sputtering vapor deposition method is effected at a lower pressure [see, e.g., Japanese Laid-Open Patent Publication Nos. H5-234919 and H11-54432 (JP5-234919A and JP11-54432A)], and that an amorphous silicon thin film is formed at a relatively low temperature by a method among various CVD and PVD methods, and thereafter a heat treatment at about 1000 deg. C or a long-time heat treatment at about 600 deg. C is effected on the amorphous silicon thin film as a post-treatment [see, e.g., Japanese Laid-Open Patent Publication No. H5-218368 (JP5-218368A)]. Such a method is also known that laser annealing is effected on an amorphous silicon film to crystallize the film [see, e.g., Japanese Laid-Open Patent Publication No. H8-124852 (JP8-124852A)].

In addition to the above, such a method has been proposed that a plasma of a gas prepared by diluting a silane-containing gas such as monosilane (SiH₄) or disilane (Si₂H₆) with hydrogen or silicon fluoride (SiF) is prepared and, in this, plasma, a crystalline silicon thin film is directly formed on a substrate at a low temperature of about 500 deg. C or lower [see, e.g., Japanese Laid-Open Patent Publication No.2000-195810 (JP2000-195810A)].

One or some of these methods, however, the deposition target substrate is to be exposed to a high temperature, in which case it is necessary to employ, as a substrate for film deposition, a substrate (e.g., silica glass substrate) which is resistant to a high temperature and thus is expensive, and it is difficult to form the crystalline silicon thin film on an inexpensive glass substrate having a low melting point and thus having a heat-resistant temperature not exceeding 500 deg. C. Therefore, the cost of the substrate increases the producing cost of the crystalline silicon thin films. A similar problem occurs when a heat treatment at a high temperature is effected on the amorphous silicon films.

In the case where the laser annealing is effected on the amorphous silicon film, a crystalline film can be obtained with a relatively low temperature. In this case, however, a laser irradiation step is required, and laser beams of an extremely high energy density must be emitted. For these and other reasons, the producing cost of the crystalline silicon thin film in this case is likewise high. Various portions of the film cannot be uniformly irradiated with the laser beams without difficulty, and further the laser irradiation may cause hydrogen desorption and thus may roughen the surface of the film so that it is difficult to obtain the crystalline silicon thin film of good quality.

In the method of forming the crystalline silicon thin film directly on the substrate at a relatively low temperature in the plasma of the gas which is prepared by diluting the silane-containing gas with hydrogen or silicon fluoride (SiF), the silane-containing gas is used by diluting it with a hydrogen gas or the like so that the film deposition speed is low. Further, the monosilane gas has the risk of spontaneous ignition in the atmosphere.

Accordingly, an object of the invention is to provide a method of forming a crystalline silicon thin film which can safely and inexpensively form the crystalline silicon thin film of good quality at a relatively low temperature, as compared with a conventional method of forming the crystalline silicon thin film.

Further, an object of the invention is to provide an apparatus of forming a crystalline silicon thin film which can safely and inexpensively form the crystalline silicon thin film of good quality at a relatively low temperature, as compared with a conventional apparatus.

### DISCLOSURE OF THE INVENTION

The inventors made a research for achieving the above objects, and found the followings.

When chemical sputtering (reactive sputtering) is effected on a silicon sputter target with plasma of Hα/SiH* from 0.3 to 1.3, a film is deposited on a deposition target object by an excitation effect of hydrogen plasma and atoms sputtered by this sputtering as well as a reaction of hydrogen radicals with a surface of a deposited film on the deposition target object and the like. This method forms a crystalline silicon thin film of good quality exhibiting crystallinity, having a small surface roughness and having a surface where hydrogen-terminated silicon's dangling bonds exist, similarly to a conventional silicon thin film formed in plasma of a gas prepared by diluting a silane-containing gas with a hydrogen gas. Further, the film deposition can be performed at a relatively low temperature, and the crystalline silicon thin film can be formed on an inexpensive glass substrate having a low-melting point and a heat-resistant temperature, e.g., of 500 deg. C or lower. This allows inexpensive formation of the crystalline silicon thin film on the deposition target object. Further, the method does not use the silane gas having the risk of spontaneous ignition in the atmosphere, which allows formation of the crystalline silicon thin film with safety.

Based on the above findings, the invention provides a method of forming a crystalline silicon thin film, wherein a hydrogen gas is supplied into a deposition chamber accommodating a silicon sputter target and a deposition target object, a high-frequency power is applied to the gas to generate plasma exhibiting Hα/SiH* from 0.3 to 1.3 in the deposition chamber, and chemical sputtering is effected on the silicon sputter target by the plasma to form the crystalline silicon thin film on the deposition target object.

Hydrogen gas plasma is generated by applying the high-frequency power to the hydrogen gas supplied into the deposition chamber, and silane radicals generated by the sputtering of the silicon sputter target with the hydrogen gas plasma are present in the plasma, and exhibit an emission spectral intensity (wavelength of 414 nm) which is represented by the above SiH*. Hα represents an emission spectral intensity of the hydrogen atom radicals exhibiting a peak at a wavelength of 656 nm by spectroscopic analysis of emission of light derived from the plasma.

Hα/SiH* represents richness of the hydrogen radicals in the plasma. When this value is lower than 0.3, the crystallinity of the deposited film lowers. When it exceeds 1.3, it conversely makes the film deposition difficult. The value of Hα/SiH* can be obtained based on a result of measurement performed by measuring the emission spectrums of various radicals with an optical emission spectroscopic analyzer for plasma. Control of Hα/SiH* can be performed by controlling at least one of a magnitude of the high-frequency power applied to the hydrogen gas, deposition gas pressure, a quantity of the supplied hydrogen gas and others.

In a typical example, the application of the high-frequency power may be performed in an inductive coupling manner utilizing the discharging from a high-frequency discharge electrode to the deposition chamber. Thereby, an inner space of the deposition chamber becomes rich in hydrogen radicals and hydrogen ions.

The inventors observed that Hα (646 nm) and Hβ (486 nm) become dominant in the plasma when producing the plasma of the hydrogen gas in the inductive coupling method and performing spectroscopic analysis of emission of light derived from the plasma. The richness with Hα and Hβ means that the hydrogen radical concentration is high. This is significantly different from the case of the plasma production by the capacitive coupling method which provides a state that Hα and Hβ are poor.

The plasma potential of the plasma formed by the application of the high-frequency power in the inductive coupling method is, e.g., about 20 eV and is very low in any case, although it depends on conditions. Therefore, a usual physical sputtering is unlikely to occur. However, the inventors observed the presence of Si (288 nm) by spectroscopic analysis of emission of light derived from the plasma. This is caused by chemical sputtering (reactive sputtering) by the hydrogen radicals and hydrogen ions at the surface of the silicon sputter target.

The high-frequency discharge electrode for application of the high-frequency power may be arranged outside the deposition chamber, or may be arranged inside the deposition chamber for efficient power application. When it is arranged outside the deposition chamber, a wall portion of the deposition chamber opposed to the high-frequency discharge electrode may be made of a dielectric material.

When it is arranged inside the deposition chamber, it is preferable to coat a surface of a conductive potion of the electrode with an electrically insulating material. By coating the surface of the electrode conductive portion with the electrically insulating material, such a situation can be suppressed that the electrode is sputtered with charged particles coming from the plasma due to a self-bias, and the sputter particles coming from the electrode are mixed into the film which is being deposited.

The insulating material may be a silica glass, or may be prepared by performing an anodizing of aluminum for the electrode.

The silicon sputter target can be provided in various states. For example, a whole or a part of a portion of the deposition chamber to be in contact with the gas plasma (e.g., an inner wall of the deposition chamber which is likely to be in contact with the plasma) is coated with silicon by silicon film formation, adhesion of silicon wafer, attachment of a silicon piece or the like to provide the silicon sputter target. The silicon sputter target independent of the deposition chamber itself may be arranged inside the deposition chamber.

In either of the cases where the high-frequency discharge electrode is arranged outside the deposition chamber, and where it is arranged inside the deposition chamber, it is preferable for smooth chemical sputtering that the silicon sputter target is located in a position opposed to at least the high-frequency discharge electrode which is a plasma generation region, and in other words, in a position near the high-frequency discharge electrode.

For example, when the high-frequency discharge electrode is located inside the deposition chamber, the silicon sputter target opposed to the high-frequency discharge electrode may be a silicon sputter target of a cylindrical form which surrounds the electrode and is opened toward the deposition target object.

In any one of the above cases, the potential of the plasma for forming the crystalline silicon thin film is preferably and substantially in a range from 15 eV to 45 eV, and an electron density is preferably and substantially in a range from 10¹⁰ cm⁻³ to 10¹² cm⁻³.

The deposition chamber pressure for forming the crystalline silicon thin film is preferably and substantially in a range from 0.6 Pa to 13.4 Pa (from about 5 mTorr to about 100 mTorr).

When the plasma potential for forming the crystalline silicon thin film is lower than 15 eV, the crystallinity lowers. When it is higher than 45 eV, the crystallinity is impaired.

When the electron density in the plasma is smaller than 10¹⁰ cm⁻³, the crystallinity lowers, and/or the deposition rate lowers. When it is larger than 10¹² cm⁻³, the film and the deposition target object are liable to be damaged.

When the deposition chamber pressure for forming the crystalline silicon thin film is lower than 0.6 Pa (about 5 mTorr), the plasma becomes unstable, and the deposition rate lowers. When it is higher than 13.4 Pa (about 100 mTorr), the plasma becomes unstable, and the crystallinity of the film lowers.

The plasma potential and the electron density of the plasma can be adjusted by controlling at least one of the magnitude of the applied high-frequency power, frequency of the power, deposition pressure and others.

The invention also provides the following apparatus of forming a crystalline silicon thin film.

Thus, the invention provides a crystalline silicon thin film forming apparatus including a deposition chamber having an object holder supporting a deposition target object; a silicon sputter target arranged in said deposition chamber; a hydrogen gas supply device supplying a hydrogen gas into the deposition chamber; an exhaust device exhausting a gas from the deposition chamber; a high-frequency power applying device applying a high-frequency power to the hydrogen gas supplied into the deposition chamber from the hydrogen gas supply device, and thereby forming plasma for effecting chemical sputtering on the silicon sputter target; an optical emission spectroscopic analyzer for plasma obtaining an emission spectral intensity Hα of hydrogen atom radicals at a wavelength of 656 nm and an emission spectral intensity SiH* of silane radicals at wavelength of 414 nm in plasma emission inside the deposition chamber; and an arithmetic unit obtaining an emission intensity ratio (Hα/SiH*) based on the Hα and SiH* obtained by the optical emission spectroscopic analyzer for plasma.

The thin film forming apparatus may further includes a control unit comparing the emission intensity ratio (Hα/SiH*) obtained by the arithmetic unit with the reference value determined in a range from 0.3 to 1.3, and controlling at least one of an output of the high-frequency power applying device, a quantity of the hydrogen gas supplied from the hydrogen gas supply device into the deposition chamber and an exhaust quantity of the exhaust device to control the emission intensity ratio (Hα/SiH*) of the plasma in the deposition chamber toward the reference value.

In this thin film forming apparatus, the high-frequency power applying device may likewise include a high-frequency discharge electrode arranged with respect to the deposition chamber for performing the high-frequency power application in an inductive coupling manner by using discharge from the high-frequency discharge electrode.

The high-frequency discharge electrode may be arranged inside the deposition chamber, in which case the silicon sputter target may be opposed at least to the high-frequency discharge electrode, similarly to the manner in the thin film forming method already described.

In the case where the high-frequency discharge electrode is arranged inside the deposition chamber, it is desired that a surface of a conductive portion of the high-frequency discharge electrode is coated with an electrically insulating material.

As described above, the invention can provides the method of forming the crystalline silicon thin film allowing inexpensive and safe forming of the crystalline silicon thin film of a good quality at a relatively low temperature.

Further, the invention can provides the crystalline silicon thin film forming apparatus which can inexpensively and safely form the crystalline silicon thin film of a good quality at a relatively low temperature as compared with the prior art.

### BRIEF DESCRIPTION OF THE DRAWINGS

Fig. 1 shows a schematic structure of an example of a film forming apparatus used for forming a crystalline silicon thin film according to the invention.
Fig. 2 illustrates a result of evaluation effected on crystallinity of a silicon film formed in an experimental example by a laser Raman spectral analysis.
Fig. 3 is a block diagram exhibiting an example of an optical emission spectroscopic analyzer for plasma.
Fig. 4 is a block diagram showing an example of a circuit controlling an exhaust quality of an exhaust device.

### PREFERRED EMBODIMENTS FOR IMPLEMENTING THE INVENTION

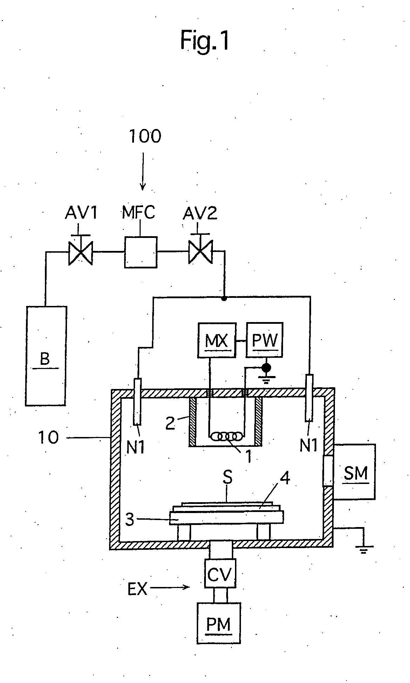

An embodiment for implementing the invention will now be described with reference to the drawings. Fig. 1 shows a schematic structure of an example of a film forming apparatus used for forming a crystalline silicon thin film according to the invention.

The film forming apparatus shown in Fig. 1 includes a deposition chamber 10, and a work or object holder 3, a high-frequency discharge electrode 1 located above the holder and a silicon sputter target 2 opposed to the electrode are arranged in the deposition chamber.

A conductor surface of the electrode 1 is coated with an insulating material made of silica glass.

The electrode 1 is connected to a discharge high-frequency power source PW via a matching box MX. The electrode 1, matching box MX and power source PW form a high-frequency power applying device. The power source PW is an output variable power source, and can supply a high-frequency power of a frequency of 13.56 MHz in this example. The power source frequency is not restricted to 13.56 MHz, and may be selected in a range from about 60 megaheltz to several hundreds of megaheltz.

The object holder 3 includes a heater 4 for heating a deposition target object or work (a substrate S in this example). The object holder 3 is grounded together with the chamber 10.

The silicon sputter target 2 has a cylindrical form surrounding and opposed to the electrode 1, and is attached to a top wall of the deposition chamber 10. The lower end of the cylindrical target 2 is opened toward the holder 3. In addition to the target 2, a silicon sputter target may be arranged on, e.g., a top wall portion of the deposition chamber surrounded by the target 2. Such a target can be arranged, e.g., by holding a silicon wafer on the top wall portion by adhesion or the like. As described above, the silicon sputter target is arranged in a position where it can be easily in contact with the plasma formed in the deposition chamber 10.

A gas inlet nozzle N1 is arranged at a top wall portion of the deposition chamber 10, and particularly in a region outside the target 2, and is connected to a hydrogen gas container B via an electromagnetic on-off valve AV2, a massflow controller MFC and an electromagnetic on-off valve AV1. These form a hydrogen gas supply device 100 for the deposition chamber 10.

In addition to the above, an exhaust device EX for exhausting a gas from the deposition chamber 10 is connected to the deposition chamber 10, and an optical emission spectroscopic analyzer SM for plasma is also employed for measuring a state of the plasma formed in the deposition chamber 10. The exhaust device EX is formed of a conductance valve CV controlling an exhaust flow rate and a vacuum pump PM connected to the chamber 10 via the valve.

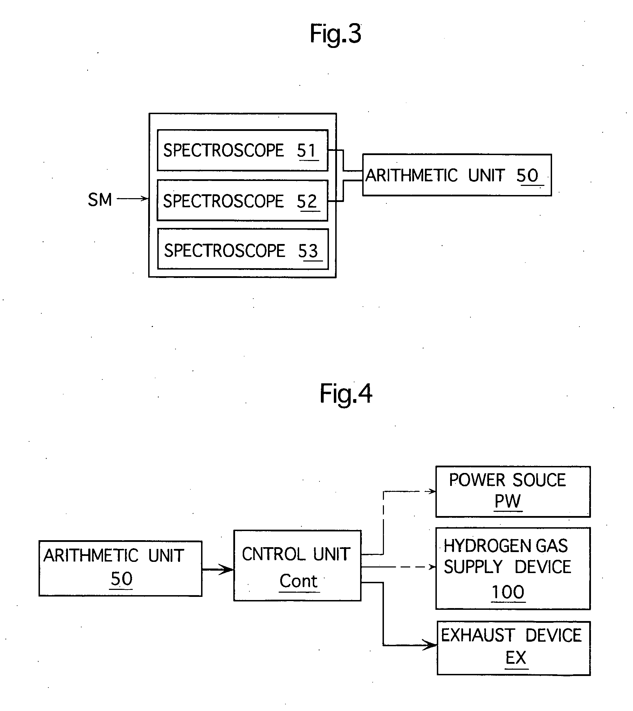

The optical emission spectroscopic analyzer SM for plasma includes, as shown in Fig. 3, a spectroscope 51 detecting an emission spectral intensity SiH* (wavelength 414 nm) of the foregoing silane radicals as well as spectroscopes 52 and 53 detecting emission spectral intensities Hα (wavelength 656 nm) and Hβ (wavelength 486 nm) of the hydrogen. The emission intensities SiH* and Hα detected by spectroscopes 51 and 52 are supplied to an arithmetic unit 50, which obtains an emission intensity ratio (Hα/SiH*).

An photosensor with a filter may be employed instead of the spectroscope(s).

Description will now be given on examples of formation of the crystalline silicon film on the substrate S by the deposition apparatus already described.

For forming the films, the deposition gas pressure in the deposition chamber is kept in a range from 0.6 Pa to 13.4 Pa. Although not shown in the figure, the deposition gas pressure can be detected, e.g., by a pressure sensor connected to the deposition chamber 10.

Prior to the film deposition, the pump PM starts to exhaust the gas from the deposition chamber 10 via the conductance valve CV.

When the pump PM lowers the inner pressure of the deposition chamber 10 below an intended deposition gas pressure, the valves AV1 and AV2 of the gas supply device 100 open to supply the hydrogen gas into the deposition chamber 10 at a flow rate controlled by the massflow controller MFC, and the output variable power source PW applies the high-frequency power to the high-frequency discharge electrode 1 so that plasma is produced from the supplied hydrogen gas in an inductive coupling manner.

From the information obtained by the optical emission spectroscopic analyzer SM from the plasma thus produced, Hα (656 nm) and Hβ (486 nm) in the plasma are obtained.

By controlling at least one of the high-frequency power applied to the electrode 1, the quantity of the hydrogen gas supplied into the chamber 10 and controlled by the massflow controller MFC, the deposition gas pressure and others, the conditions such as the high-frequency power and the quantity of the supplied hydrogen gas are determined such that the emission intensity at Hα (656 nm) and Hβ (486 nm) in the plasma may be sufficiently large.

The conditions such as the high-frequency power and the quantity of the supplied hydrogen gas are determined such that Hα/SiH* in the hydrogen plasma falls within a range from 0.3 to 1.3, the potential of the plasma falls within a range from 15 eV to 45 eV and the electron density in the plasma falls within a range from 10¹⁰ cm⁻³ to 10¹² cm⁻³.

The plasma potential and the electron density can be checked, e.g., in the Langmuir probe method.

In view of the above, the conditions such as the high-frequency power, quantity of the supplied hydrogen gas and the deposition gas pressure are finally determined.

After determining the deposition conditions, the film deposition is performed according to the determined conditions.

For the film deposition, the heater 4 is set to heat the deposition target substrate S held by the holder 3 to a relatively low temperature not exceeding 500 deg. C and, e.g.; to about 400 deg. C, and the deposition target substrate S is placed on the holder 3. The pump PM exhausts the gas from the deposition chamber 10, and subsequently the hydrogen gas supply device 100 supplies a predetermined amount of the hydrogen gas into the deposition chamber 10. Also, the power source PW applies the high-frequency power to the electrode 1. Thereby, the electrode 1 performs the discharging in the inductive coupling manner to generate the plasma.

Thereby, the plasma effects the chemical sputtering (reactive sputtering) on the silicon sputter target 2 opposed to the electrode 1, and thereby the silicon thin film is formed on the substrate S. Similarly to the crystalline silicon thin film formed in conventional gas plasma which is obtained by diluting a silane-containing gas with a hydrogen gas, this film is the silicon thin film exhibiting the crystallinity, and has a surface where hydrogen-terminated silicon's dangling bonds exist.

If the substrate temperature in film deposition excessively low, it is difficult to crystallize the silicon so that a substrate temperature of or above 200 deg. C is substantially desired although it specifically depends on other conditions.

An example of an experiment of forming a crystalline silicon thin film will now be described.

The conditions and others are as follows:
Substrate: non-alkali glass substrate
Substrate temperature: 400 deg. C.
High-frequency power source: 13.56 MHz, 2000 W
Hydrogen gas supply quantity: 50 sccm
Deposition pressure: 13 Pa (98 mTorr)
Hα/SiH* in plasma: 1.0
Plasma potential: 30 eV
Electron density in plasma: 10¹¹ cm⁻³
Film thickness: about 500 Å

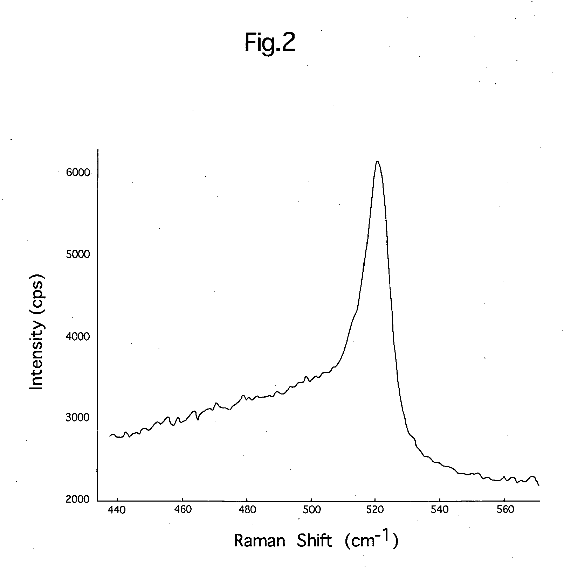

A crystallinity of the film obtained in this example was evaluated by laser Raman spectroscopic analysis. According to the result, a peak exhibiting the crystallinity of Raman shift 520 cm⁻¹ was present as illustrated in Fig. 2, and the crystallinity was confirmed.

In the formation of the silicon thin film already described, manual operations are performed for controlling the output of the power source PW, the hydrogen gas supply quantity of the hydrogen gas supply device 100, the exhaust quantity of the exhaust device EX determining the deposition chamber pressure and others.

As illustrated in Fig. 4, however, the emission intensity ratio Hα/SiH* obtained by the arithmetic unit 50 connected to the optical emission spectroscopic analyzer SM for plasma may be supplied to a control unit Cont. The control unit Cont determines whether the emission intensity ratio Hα/SiH* provided from the arithmetic unit 50 is equal to a predetermined reference emission intensity ratio (reference value) or not. When it is not equal to the reference emission intensity ratio, the control is effected on ,e.g., at least one of the output of the output variable power source PW, the hydrogen gas supply quantity of the hydrogen gas supply device 100, and the exhaust quantity of the exhaust device EX. A structure performing the above control may be employed.

As a specific example, the control unit Cont may control the conductance valve of exhaust device EX to control the exhaust quantity of the device EX, and thereby the gas pressure in the deposition chamber 10 may be controlled to attain the reference emission intensity ratio.

In the above case, the initial values determined in advance by experiments or the like may be employed for the output of the output variable power source PW, the hydrogen gas supply quantity of the hydrogen gas supply device 100, the exhaust quantity of the exhaust device EX and others such that the reference emission intensity ratio or the value close to it may be obtained.

When determining the above initial values, the exhaust quantity of the exhaust device EX is likewise determined to keep the pressure in the deposition chamber 10 within a range from 0.6 Pa to 13.4 Pa. Also the initial values are determined such that the potential of the plasma may fall within the range from 15 eV to 45 eV, and the electron density in the plasma may fall within the range from 10¹⁰ cm⁻³ to 10¹² cm⁻³.

The output of the power source PW and the hydrogen gas supply quantity of the hydrogen gas supply device 100 will be kept at the initial values, respectively, and the exhaust quantity of the exhaust device EX will be controlled by the control unit Cont to achieve the reference emission intensity ratio.

### INDUSTRIAL APPLICABILITY

The invention can be utilized in the cases of forming crystalline silicon thin films for forming various semiconductor parts, semiconductor devices and others such as TFT (thin film transistor) switches that utilize the crystalline silicon thin films.

## Claims

1. A method of forming a crystalline silicon thin film, wherein
a hydrogen gas is supplied into a deposition chamber accommodating a silicon sputter target and a deposition target object, a high-frequency power is applied to said gas to generate plasma exhibiting Hα/SiH* from 0.3 to 1.3 in said deposition chamber, and chemical sputtering is effected on said silicon sputter target by said plasma to form the crystalline silicon thin film on said deposition target object.

2. The method of forming the crystalline silicon thin film according to claim 1, wherein
the application of said high-frequency power is performed in an inductive coupling manner utilizing a discharging from a high-frequency discharge electrode arranged with respect to the deposition chamber.

3. The method of forming the crystalline silicon thin film according to claim 2, wherein
said high-frequency discharge electrode is arranged inside said deposition chamber, and said silicon sputter target is opposed to at least said high-frequency discharge electrode.

4. The method of forming the crystalline silicon thin film according to claim 3, wherein
a surface of a conductive portion of said high-frequency discharge electrode is coated with an electrically insulating material.

5. The method of forming the crystalline silicon thin film according to any one of the preceding claims 1 - 4, wherein
a potential of said plasma for forming said crystalline silicon thin film is in a range from 15 eV to 45 eV, and an electron density is in a range from 10¹⁰ cm⁻³ to 10¹² cm⁻³.

6. The method of forming the crystalline silicon thin film according to any one of the preceding claims 1 - 5, wherein
said deposition chamber pressure for forming said crystalline silicon thin film is in a range from 0.6 Pa to 13.4 Pa.

7. A crystalline silicon thin film forming apparatus comprising a deposition chamber having an object holder supporting a deposition target object; a silicon sputter target arranged in said deposition chamber; a hydrogen gas supply device supplying a hydrogen gas into said deposition chamber; an exhaust device exhausting a gas from said deposition chamber; a high-frequency power applying device applying a high-frequency power to the hydrogen gas supplied into said deposition chamber from said hydrogen gas supply device, and thereby forming plasma for effecting chemical sputtering on said silicon sputter target; an optical emission spectroscopic analyzer for plasma obtaining an emission spectral intensity Hα of hydrogen atom radicals at a wavelength of 656 nm and an emission spectral intensity SiH* of silane radicals at wavelength of 414 nm in plasma emission inside said deposition chamber; and an arithmetic unit obtaining an emission intensity ratio (Hα/SiH*) based on the Hα and SiH* obtained by said optical emission spectroscopic analyzer for plasma.

8. The crystalline silicon thin film forming apparatus according to claim 7, further comprising a control unit comparing the emission intensity ratio (Hα/SiH*) obtained by said arithmetic unit with the reference value determined in a range from 0.3 to 1.3, and controlling at least one of a quantity of the hydrogen gas supplied from said hydrogen gas supply device into said deposition chamber and an exhaust quantity of the exhaust device to control the emission intensity ratio (Hα/SiH*) of the plasma in said deposition chamber toward said reference value.

9. The crystalline silicon thin film forming apparatus according to claim 7 or 8, wherein said high-frequency power applying device includes a high-frequency discharge electrode arranged with respect to said deposition chamber for performing the high-frequency power application in an inductive coupling manner by using discharge from said electrode.

10. The crystalline silicon thin film forming apparatus according to claim 9, wherein said high-frequency discharge electrode is arranged inside said deposition chamber, and said silicon sputter target is opposed at least to said high-frequency discharge electrode.

11. The crystalline silicon thin film forming apparatus according to claim 10, wherein a surface of a conductive portion of said high-frequency discharge electrode is coated with an electrically insulating material.
